# EUROPEAN PATENT APPLICATION

(11) **EP 1 320 117 A2**
(43) Date of publication of application: **18.06.2003**
(21) Application number: 02027938.6
(22) Date of filing: 13.12.2002
(51) Int. Cl.: H01J 37/305

(54) **Method for defect and conductivity engineering of a conducting nanoscaled structure**

(30) Priority: 13.12.2001 EP 01129710
(71) Applicant: Sony International (Europe) GmbH, 10785 Berlin (DE)
(72) Inventor: Harnack, Oliver, c/o Ad. Tech. Center Stuttgart, 70327 Stuttgart (DE); Ford, William E., c/o Ad. Tech. Center Stuttgart, 70327 Stuttgart (DE); Wessels, Jurina, c/o Ad. Tech. Center Stuttgart, 70327 Stuttgart (DE); Yasuda, Akio, c/o Ad. Tech. Center Stuttgart, 70327 Stuttgart (DE)
(74) Representative: Appelt, Christian W.

(57) **Abstract**

The invention relates to a method for defect (36) and conductivity engineering of a conducting nanoscaled structure (22) or at least one part of it by generating heat-induced migration, melting, sputtering and/or evaporation of conductive material of the nanoscaled structure by directing a focused electron beam on the nanoscaled structure or an individual portion (36) of it to be engineered and/or by applying one or multiple wires of the conducting nanoscaled structure by applying a current density J_{D,I} whereas the current density J_{D,I} has a value below a critical current density J_{C} which is the current per cross-section area of the wire at which the wire fails due to overheating and electromigration, and not lower than 3 orders of magnitude below J_{C}. The invention further relates to the use of a secondary electron microscope having a filter for detecting back scattered electrons for such a method and a respective secondary electron microscope having such a filter for detecting back scattered electrons.

## Description

The invention is related to a method for defect and conductivity engineering of a conducting nanoscaled structure or of an individual portion or an individual region in or an element of such a nanoscaled structure. The term "defect and conductivity engineering" has to be understood in the sense of this invention in its broadest possible extent and comprises both a defect repairing of conducting nanoscaled structures, i.e. a connecting of nanoscaled structures having a gap between gap edges, as well as the amendment or tuning of the conductivity of a nanoscaled structure or of an individual part thereof, i.e. both enhancing and lowering of the conductivity of the nanoscaled structure or of specific portions or elements thereof, even in case there is no real "gap" in the respective wire or structure. With the term "engineering of an individual portion" all treatments are covered, which are directed and targeted only to a portion, a part of the nanoscaled structure and not simultaneously treating the complete nanoscaled structure in an identical way, however, the invention also covers an engineering of complete wires or also multiple wires of a nanoscaled structure of even the complete nanoscaled structure.

In the publication "Carbon Nanotube Template Self-Assembly and Thermal Processing of Gold Nanowires" of S. Fullam (Advanced Materials (2000), 12, No. 19, pages 1430 ff.) a method for enhancing conductivity of a nanoscaled structure assembly is disclosed, wherein the complete assembly is heated to higher temperatures in the area of 300° C for a time of up to 120 seconds, generating a fusion between neighboring crystals of the nanoscaled structure.

Florian Banhart disclosed in his publication "The Formation of a Connection between Carbon Nanutubes in an Electric Beam" (Nano Letters 2001, Vol. 1, No. 6, pages 329 to 332) the possibility of connecting crossing mulitwalled nanotubes by aggregating hydrocarbons and transferring them into amorphous carbon, which is immobile and remains in the irradiated area, whereby two crossed nanotubes are soldered together and a mechanical junction is established between them.

T.R. Groves describes in his publication "Theory of beam-induced substrate heating" (J.Vac. Sci. Technol. B 14(6), Nov/Dec 1996, pages 3839 ff, by American Vacuum Society 1996) a general analysis of beam induced substrate heating and the dependencies of heating and beam power and pattern density.

It is an object of the present invention to provide a method for defect and conductivity engineering of a conducting nanoscaled structure or of an individual portion in such a conducting nanoscaled structure, whereby this method should be fast and reliable and which should, according to a further aspect, provide the possibility to be further combined with a preferably automatic defect and conductivity inspection method. It is further a specific object of the present invention to provide such a method by aiming and targeting only individual portions of the structure while leaving other parts of the conducting nanoscaled structure essentially unchanged, however, also treatment of complete wires or multiple wires and even the complete nanoscaled structure should be covered by the present invention.

This object is achieved by a method according to claim 1 and the use of a scanning electron microscope SEM according to claim 28. Claims 2 to 27 are referring to specific advantageous realizations of the inventive method, claims 29 and 30 refer to advantageous embodiments of the scanning electron microscopy used for such a method.

According to the invention a method for defect and conductivity engineering of a conducting nanoscaled structure or of an individual portion in such a structure is provided, which generates heat-induced migration, melting, sputtering and/or evaporation of conductive material of the nanoscaled structure by directing a focused electron beam on the structure or on an individual portion of such a structure to be engineered.

Further, according to the invention, a method for defect and conductivity engineering by applying one or multiple wires of the conducting nanoscaled structure by applying a current density J_{D,I}, whereas the current density J_{D,I} has a value below a critical current density J_{C}, which is the current per cross-section area of the wire at which the wire fails due to overheating and electro-migration, and not lower than 3 orders of magnitude below J_{C} is provided.

This application of a certain current density is referred to hereinafter also as "current-annealing"

The invention is therefore especially, but not exclusively, directed to conductivity engineering of individual portions or parts of a nanoscaled structure, especially for closing gaps or defects, but also for conductivity engineering of larger parts, especially complete wires or multiple wires of a conductive nanoscaled structure or even the complete nanoscaled structure.

According to one aspect, the beam-inducted heating of the targeted conducting structure is the origin for the material modification effect, namely migration, melting, sputtering and/or evaporation. The method according to the present invention thereby provides an easily applicable method for repairing of defects, the enhancement and the tuning of conductivity along nanoscaled conducting structures of a wide variety, especially as the inventive method is adaptable to the different nanoscaled conducting structures and its physical properties, especially its melting points etc.

Especially the biasing of wires or multiple wire assemblies of the conductive nanoscaled structure with a current density however enables not only the conductivity engineering of limited parts of a nanoscaled structure, especially also parts of a wire within a nanoscaled structure, but especially conductivity engineering of complete wires or multiple wire assemblies.

By using a focused electron beam it is possible to treat defects, i.e. segments of reduced conductivity or even gaps, reducing the conductivity to zero, without influencing other parts of the nanoscaled conducting structure. An engineering of a nanoscaled structure according to specific requirements, especially the constructing of specific nanoscaled designs is therefore possible, which is especially important for providing nanoscaled structures as a basis for manufacturing of miniaturized processing data devices, e.g. integrated areas of nanometer-scaled circuits e.g. from metal and semiconductor nanocrystals or other materials.

The invention is especially useful for providing conducting nanoscaled structures of DNA-templated nanowires, which were made highly conductive by selective, self-assembly driven metallisation or e.g. polycrystalline metal nanowires.

The above mentioned conducting nanoscaled structures comprising DNA nanowires are usually prepared on silicon substrates having an oxide thickness between 2 nm and 500 nm, however the inventive method is also applicable to conducting nanostructures on various kinds of substrate materials.

The inventive method can further be used to fuse together grain boundaries or individual nanocrystals, e.g. in order to increase the conductivity of a granular conducting structure. Also these grain boundaries or individual nanocrystals should be understood as "conducting nanoscaled structures" in the sense of this invention.

The inventive method is preferably applicable to a gap region in a conducting nanoscaled structure, whereby the focused electron beam is directed onto the gap region covering also the defect edges. Thereby the generated heat induced migration by melting, sputtering and/or evaporation of the conductive material at this defect edges leads to a filling of the gap and a connection of said defect edges, thereby closing the gap and providing a conductive nanoscaled structure.

The parameters of the focused electron beam are dependent on the material of the conducting nanoscaled structure as well as on the desired effect and can be adopted to the nanoscaled structure to be engineered.

Preferred beam voltages, especially for above mentioned DNA-templated nanowires, which can be e.g. metallised by selective plating with gold, but also for other materials and nanoscaled structures, are preferably in a range of 0,1 to 50 kV, especially between 3 and 10 kV and most preferably in the range of about 5 kV.

Preferred current densities are in the range of 1 to 100 A/cm², especially in the range of 10 to 50 A/cm² and most preferably in the range of about 20 A/cm². Preferred absolute beam currents are in the range of 10 to 1000 pA, preferably in the range of 20 to 500 pA, most preferably in the range of 200 to 400 pA. The application of such low energy beams is sufficient to realize the engineering, especially the defect repair and enhancement of the conductivity, within short application times, preferably in the area of about 2 to 30 seconds, normally between 10 to 20 seconds, especially in the case of the above mentioned metallised DNA nanowires, however the application time or scanning time is of course dependent on the nanoscaled structure material and the substrate material. Depending on the material properties, especially the thermal conductivity of the material to be engineered, application time can also rise up to one minute or in specific cases also up to several minutes.

A scanning window for the electron beam is preferably adjusted to the defect region (or region to be engineered in general), whereas the defect, or the region to be engineered, has to be centered within the scanning window. The scan window can have different geometrical forms, having typically a diameter between 10 and 100 nm in case of generally circular scan windows or side lengths of between 10 to 100 nm in case of rectangular scan windows. Preferably the diameter or the side lengths of the scanning window are between 50 nm and 100 nm.

It is however also possible to utilize smaller dimensions for the scanning windows and to also omit scanning of the electron beam but directly focussing the electron beam on a particular spot on the center or position to be engineered. Generally in case of scanning, the diameter of the electron beam is smaller than in case of a direct focussing of the electron beam.

Typical electron beam diameters are in the range 1 to 50 nm, especially in the range of 5 to 20 nm, preferably at about 10 nm.

A preferred electron dose is in the range between 1 to 500 mC/cm², preferably between 10 and 200 mC/cm², especially in the range of above 50 mC/cm² to 100 mC/cm² for one step of engineering of a particular region of the nanoscaled structure. The electron dose can however also range up to several tens of C/cm², preferably in the range of 10 to 50 C/cm².

Especially with relative high electron doses of above 20 mC/cm² very high surface temperatures can be achieved, causing the above described structural changes in the metallised na-nostructure by migration, melting, sputtering and/or evaporation of the conductive material.

According to an independently inventive aspect of the invention it is also possible to inspect a conducting nanoscaled structure by directing an electron beam onto the part of the structure to be inspected and detecting backscattered electrons.

In this respect it is important to notice that the backscattered electrons carry the required electronic information about the surface, allowing the inspecting and investigation of the conductivity of the nanoscaled structure, whereas secondary electrons, generated by the primary electrons of the electron beam, do in general not provide useful contrast variations related to conductivity variations but normally carry only topologic information of the surface.

It is therefore preferred to implement a filter for detecting only the backscattered electrons, whereas the term "filter" in this sense has to be understood in its broadest possible sense, comprising e.g. specific detectors or specific detector arrangements or also one or more acceleration or retardation fields possibly in combination with different detector elements, in order to receive or calculate a signal or information only or also mainly based on the backscattered electrones.

The analysis of the backscattered electrons according to this aspect of the invention therefore provides a backscattered electron picture having contrast information being directly related to the presence of defects in a conducting nanoscaled structure or the conductivity in this nanoscaled structure respectively.

Although this inspection of a conducting nanoscaled structure by directing an electron beam onto the part of the structure to be detected is, as mentioned above, an independent inventive aspect of the invention, special advantages are achieved by combining the method for inspecting conducting nanoscaled structures and a method for defect and conductivity engineering of such a conducting nanoscaled structure, as explained above, by utilizing a focused and directed electron beam.

In a very easy manner and by utilizing only one device it is therefore possible to first check and inspect a conducting nanoscaled structure and to directly repair or engineer certain parts of the nanoscaled structure after having detected certain defects, or areas/portions that should be "amended" or engineered.

According to an especially advantageous realization of the invention both methods for inspecting and engineering are applied together in a sequence, preferably alternating, so that first a nanoscaled structure will be examined and, in case of defects, engineered, whereby after an engineering step again inspecting of the amended nanoscaled structure is performed, in order to avoid an "over-engineering", i.e. an undesired over-treatment leading to overheating and undesired migration, melting, sputtering and/or evaporation of the conductive material.

It is also possible to perform the step of inspecting said conducting nanoscaled structure simultaneously to the generating of the heat-induced migration, melting, sputtering and/or evaporation.

It has to be mentioned that in general a lower power for the electron beam has to be used for inspecting the conducting nanoscaled structure in comparison to the engineering, in order to avoid any amending or engineering effect when only inspecting the nanoscaled structure or to keep at least such effects as low as possible, when only an inspecting of the nanoscaled structure is desired.

The preferred electron beam parameters for engineering have been already referred to above, in case of an electron beam for inspecting, the electron dose should be normally below several mC/cm², preferably below 10 mC/cm². Preferred electron doses are in the range of 1 to 5 mC/cm², whereas also very small electron doses below 1 mC/cm² are possible, e.g. preferably in the range of 1 to 500 µC/cm². When comparing the electron dose for inspecting with the electron dose for engineering, the engineering electron dose is preferably about a magnitude higher, preferred engineering electron doses do exceed the inspecting electron doses by a factor 5 to 100, preferably by a factor 10 to 50 and in a most of the cases by a factor 10 to 30.

The beam current for inspecting is preferably between 10 to 500 pA, more preferably between 20 to 100 pA and especially in the range of about 50 pA.

A preferred scanning window is about in the same range as a preferred scanning window for engineering, having side lengths of about 10 to 100 nm, preferably between 50 nm and 100 nm in case of a rectangular form. Although it is also possible to omit scanning also in inspecting modus and to directly focus the electron beam on a particular spot on a portion to be inspected, such an operation is normally not preferred during inspection but only in an engineering modus.

Preferred acceleration voltages in an inspecting modus are in the range of 0,1 to 50 kV, especially between 1 and 10 kV, thereby comparable to the accelerating beam voltage in case of an engineering electron beam, but normally slightly lower, preferably lower by a factor of about 1,5 to 3.

In case of an inspecting modus it is especially preferred that the nanoscaled structure is attached to an electrode, which serves as an electron reservoir. This will greatly enhance the image contrast, if defects are present. Alternatively, the nanoscaled structure could be just attached to a thin conducting line, which provides a certain voltage bias of the nanoscaled structure from outside. This would also lead to a certain contrast enhancement.

On the other hand, for the engineering, as mentioned above, such an attachment of the nanoscaled structure to an electrode or a thin conducting line is not required, but it is also possible to have the nanoscaled structure attached to an electrode also during engineering without negatively influencing the engineering process.

In a preferred realization of the method or the step of inspecting of said conducting nanoscaled structure a beam of primary electrons is accelerated in a high voltage electrical field and the electrons are then retarded by a retarding field before reaching the conducting nanoscaled structure, whereby in a preferred embodiment a first detection means only detects backscattered electrons preferably accelerated by said retarding field in direction to said first detection means, and a second detection means detects a mixture of both secondary electrons and backscattered electrons, whereby a backscattered electron signal or backscattered electron picture can be determined especially by comparison of the measurement of the both detection means.

In one embodiment the retardation field retards the primary electrons of the electron beam to an energy of about 2% to 10% of its maximum energy generated by said high voltage electrical field.

It has to be mentioned that the retarded beam can actually have beam voltages between about 100 V and 10 keV, and can therefore be below 1 % and up to 100 % of the maximum energy generated by above mentioned high voltage electric field, whereas the retarded beam has been voltages preferably between 10 % and 100 %.

When biasing wires or multiple wires in a conductive nanoscaled structure with a current density J_{D,I} being below a critical current density J_{C} which is the current per cross section area at which the wire fails due to overheating and electromigration, essentially complete wires or an assembly of wires are conductivity engineered.
Depending on the current density J_{D,I} applied, the conductivity or resistivity can be decreased or increased, whereas a lower current density J_{D} is preferably used for decreasing resistivity and a higher current density J_{I} is utilized for increasing resistivity.

Preferably, the current density J_{D} for decreasing the resistivity is in an area between about 1% and 10 % of the critical current density J_{C}, preferably in an area between 2% and 9%, especially between 5% and 8% of the critical current density J_{C}.

For increasing the resistivity the current density J_{I} is closer to the critical current density J_{C} and higher than J_{D} as described above, and preferably in an area between about 10% and 90% of J_{C}, preferably between 30% and 90% of J_{C} and preferably above 50% of J_{C}.

Biasing of the wire with a current density J_{D} or J_{I} is preferably conducted over a time period of less than 5000 seconds, preferably less than 1000 seconds or even less than 500 seconds, a preferred application time is normally between 1 to 5 seconds and 400 seconds, especially between 100 and 250 seconds.

The typical application of a focus electron beam will normally not be longer than 6000 seconds, preferred application times will be especially between 1 second and 4000 seconds, especially between 500 or 1000 and 3000 seconds.

It has further to be mentioned that normally the directing of a focused electron beam and the biasing of the wires will be performed independently, i.e. not at the same time, it is however also possible to at the same time both bias the conducting nanoscaled structure by a certain current density and apply a focused electron beam, especially on certain parts of the nanoscaled structure or certain parts of a wire.

The object of the invention is further solved by the use of a scanning electron microscope SEM system for a method as described above, whereas the scanning microscope having a filter for detecting backscattered electrons and secondary electrons and having a filter for detecting essentially only backscattered electrons (whereas "filter" in the sense of this invention relates to any means leading to a "backscattered electron picture" or respective signal, as mentioned above).

Further features and advantages of the present invention will become more apparent in view of the following drawings:
- Fig. 1: shows a backscattered electron picture of nanoscaled metallised DNA-wires connected to electrons;
- Fig. 2: shows a backscattered electron picture of the system shown in figure 1 before (Figure 2a) and after cutting a nanoscaled metallised DNA-wire (Figure 2b);
- Fig. 3: shows an enlarged detail of a backscattered electron picture of a nanoscaled metallised DNA wire system with a defect in a single metallised DNA-templated nanowire;
- Fig. 4: shows the same enlarged detail of the backscattered electron picture of the system shown in figure 3 after the defect in the single metallised DNA-templated nanowire has been repaired;
- Fig. 5: shows a schematic drawing of an embodiment SEM adopted to the inventive method with indicated paths of backscattered and secondary electrons.
- Fig. 6: shows an SEM image of a single metallized DNA nanowire on a polysterene surface, whereas this metallized DNA has been "current-annealed " according to the invention;
- Fig. 7: shows the resistance versus time during a current-annealing treatment according to the invention of a metallized DNA wire according to Fig. 6;
- Fig. 8a: shows a further SEM picture of a DNA wire;
- Fig. 8b: shows the resistance versus time during an electron-beam assisted fusing process of the entire wire according to the invention;
- Fig. 9a: shows a further SEM picture of a system with a defect location;
- Fig. 9b: shows a resistance versus time for an electron-beam assisted fusion process of the system shown in Fig. 9a according to the invention;
- Fig. 10a: shows a further SEM picture of a defect location;
- Fig. 10b: shows a resistance versus time for an electron-beam assisted fusion process of the system shown in Fig. 10a according to the invention;
- Fig. 11a: shows an SEM picture of a further defect location;
- Fig. 11b: shows a resistance versus time for an electron-beam assisted fusion process of the system shown in Fig. 11 a according to the invention.

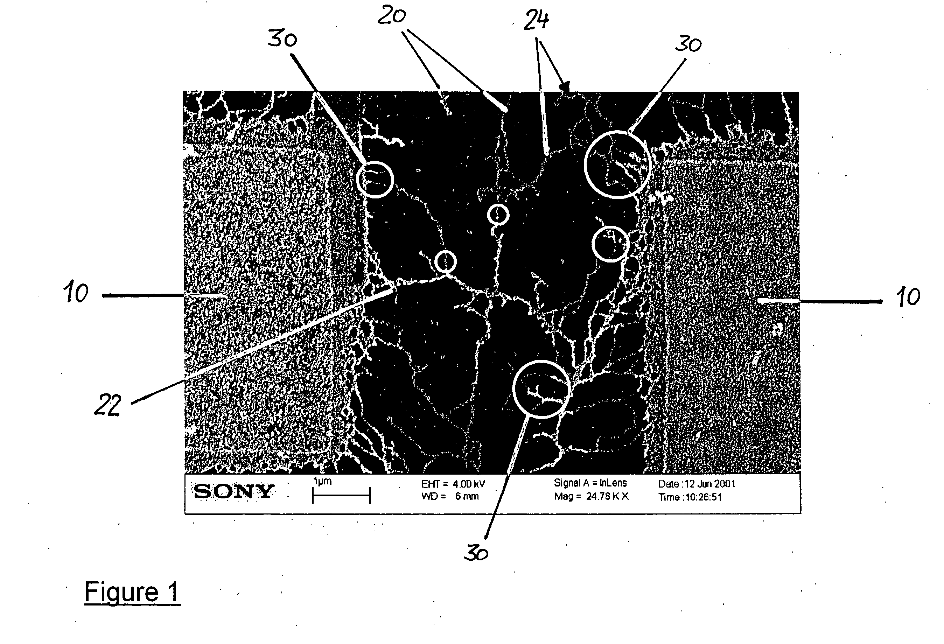

Figure 1 shows a backscattered electron picture of two electrodes 10 and a system of DNA-templated nanowires 20, 22, 24, which were made highly conductive by selective, self-assembly driven metallisation, whereas this picture is taken by directing an electron beam onto the system to be inspected and by detecting the backscattered electrons according to one aspect of the invention. The backscattered picture shown in figure 1 has been achieved with a beam voltage of 4 kV and a working distance WD of 6 mm.

In the system shown in figure 1, the DNA-templated nanoscaled wires are randomly aligned, however, for circuits in e.g. nanoelectronics, better defined alignments can be realized.

As clearly visible in figure 1, the DNA-templated nanowires 20, 22, 24 do show either a bright contrast or a weak contrast. Those wire parts 22 which are electrically connected to at least one electrode 10 show a bright contrast whereas those wire parts 24, which obviously have no direct electrical contact to one of the electrodes 10, appear with a weak contrast.

A number of defects 30, indicated in figure 1 by white circles, are also clearly visible in figure 1.

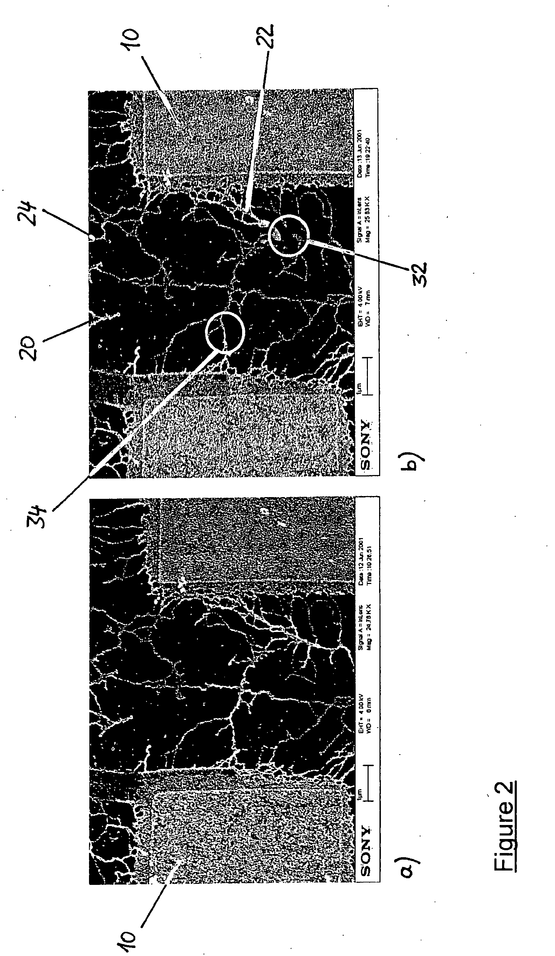

Figure 2a shows the system of figure 1 for better comparison and figure 2b shows the same system after an additional defect 32, indicated also by a white circle, has been introduced into the system by an AFM (atomic force microscope) tip assisted cutting of a conducting part of the DNA-templated wire.

As now clearly visible by generating this additional defect 32 some DNA-templated wires 22 are disconnected from the electrodes 10 by said additionally introduced defect 32 and do thereby appear only with a weak contrast.

Due to the additionally introduced defect 32, a further defect 34 was discovered, clearly visible due to the DNA-templated wire 22 showing a bright contrast on the left side of the defect 34 and the DNA-templated wire 22 showing a weak contrast on the right side of the defect 34.

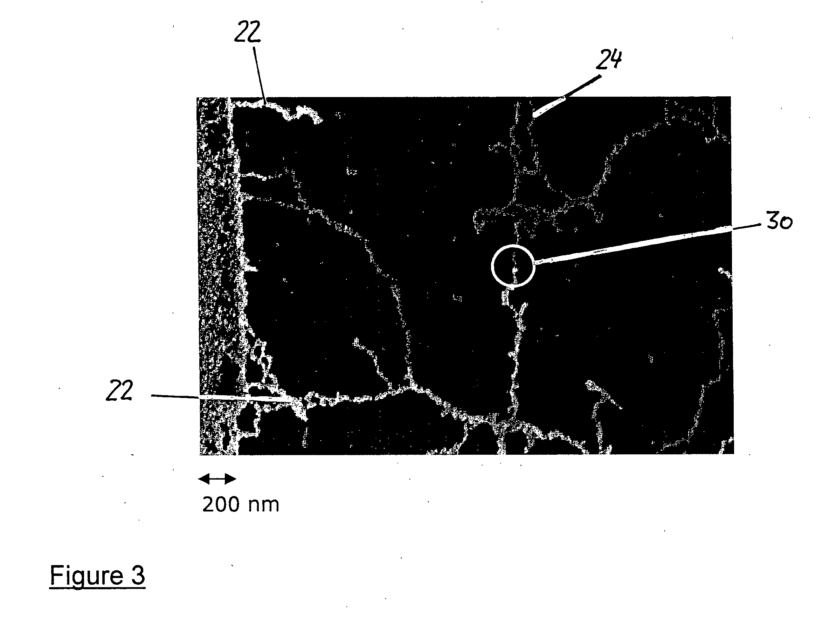

Figure 3 shows an enlarged detail of a backscattered electron picture with DNA-templated nanowires 22 connected to electrodes (not shown) and therefore showing a bright contrast and with DNA-templated nanowires 24, not being connected to electrodes (not shown) and therefore showing only a weak contrast. As clearly visible at about the center of the backscattered electron picture of figure 3 a defect 30 could be detected, separating nanowires 24 not being in contact with an electrode (weak contrast, above defect 30) and nanowires 22, being connected to an electrode (bright contrast, below defect 30).

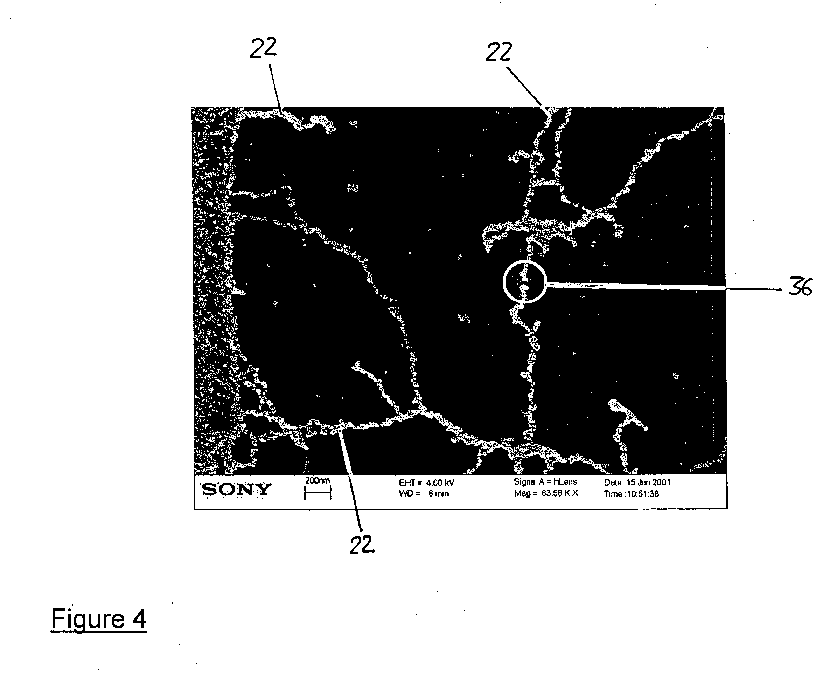

By applying the inventive method and utilizing a focused electron beam with an energy of 4 kV, WD 6mm, beam current approximately 20 pA, aperture 30 µm, scanning window approximately 50 nm by 100 nm, scanning time 10 seconds, the defect 30 has been bridged so that the defect has been repaired (designation number 36 in figure 4).

In Figure 4 both above and below the repaired defect 36 the DNA-templated nanowires 22 do now show a bright contrast in the backscattered electron picture, clearly indicating that the DNA-templated nanowires 22 both below and above the repaired defect 36 are now connected to one electrode, indicating that the defect (30, see figure 3) has clearly been repaired and conductively bridged.

Although the examples shown in the figures do show the effects of the inventive method by showing backscattered electron pictures, it has to be understood that the method for defect and conductivity engineering can also be applied independently on the method or the step of inspecting said conductivity nanoscaled structure by a backscattered electron picture, although this combination is, as mentioned above, preferred, as by a combination leading to inventive combinatory advantages. The conducting nanoscaled structure can however e.g. also be inspected, in order to e.g. find defects or segments of reduced conductivity, by e.g. optical or infrared variations or by electrical measurements or also by structural investigations using atomic force microscopy.

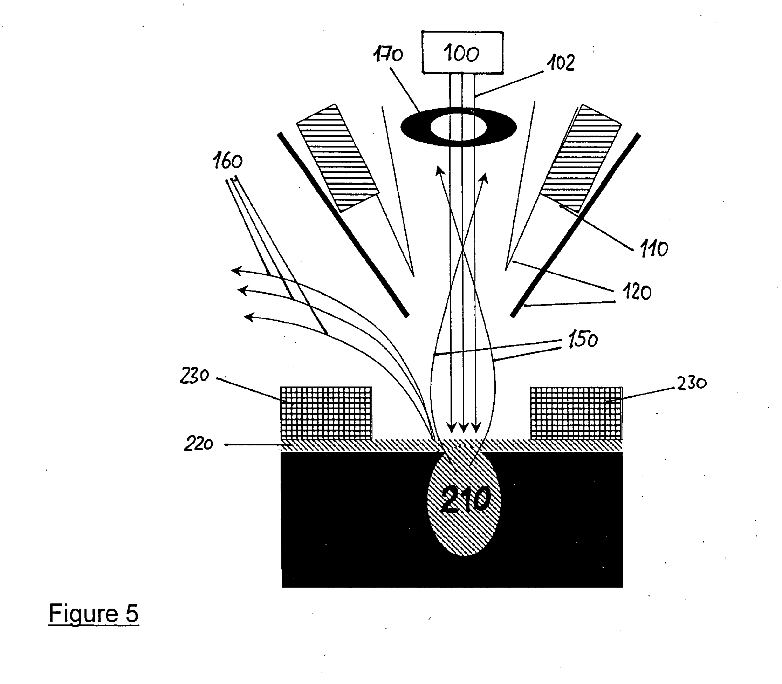

Figure 5 schematically shows some of the main elements of an embodiment of an SEM system used for the inventive method. A primary electron beam 102 is generated by an electron source 100, whereas the acceleration voltage can be adjusted in a wide area, being preferably, according to the inventive method, in the range of 1 kV to 10 kV.

The primary electron beam 102 is directed onto a sample 200 having a nanoscaled structure. The sample 200 is shown only schematically, having two electrodes 230 attached on the upper surface of the sample 200.

As schematically indicted in figure 5, the primary electron beam 102 directed onto the sample 200 shows effects mainly within an interaction volume 210 in the sample. The interaction volume 210 is shown only schematically in this drawing and is dependent of the material of the sample 200 and the parameters of the electron beam.

The primary electron beam 102 generates backscattered electrons 150 and secondary electrons 160, whereas the backscattered electrons 150, having essentially the same energy as the primary beam electrons 102, are backscattered essentially in a direction being opposite to the primary electron beam, whereas the secondary electrons 160 are generated in a sideward direction, as schematically indicated in figure 5.

The direction of the electrons is controlled by magnetic lenses 110 and electrostatic lenses 120 of the SEM.

The SEM shown in figure 5 comprises an annular detector 170 for backscattered electrons 102, so that a signal for the backscattered electrons can be taken directly and a "backscattered electron picture" can be generated.

Although not shown in figure 5, the SEM can of course also comprises a detector for the secondary electrons 160 preferably a lateral detector. It should be mentioned at this point that the secondary electrons 160 are generated only in a secondary emission region 220 in the upper surface region of the sample 200 as schematically indicated in figure 5.

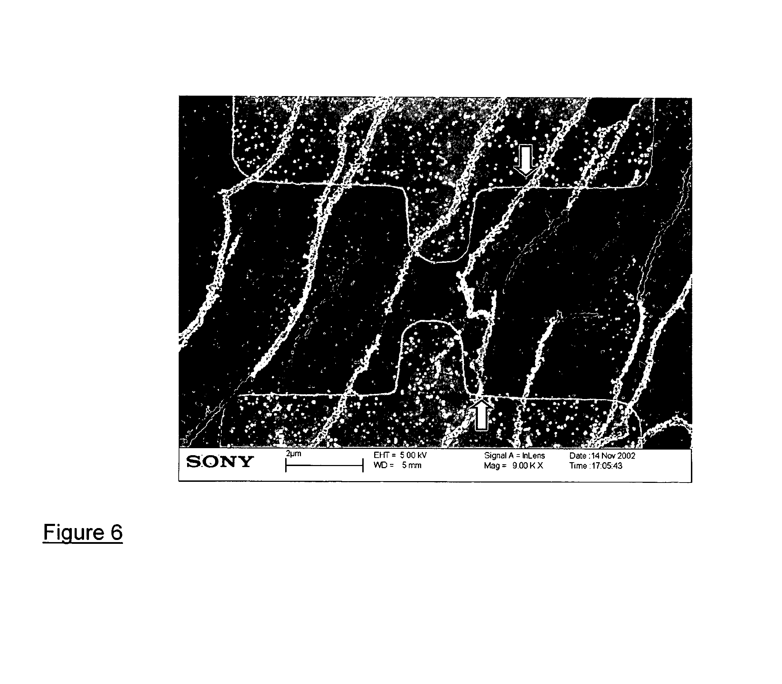

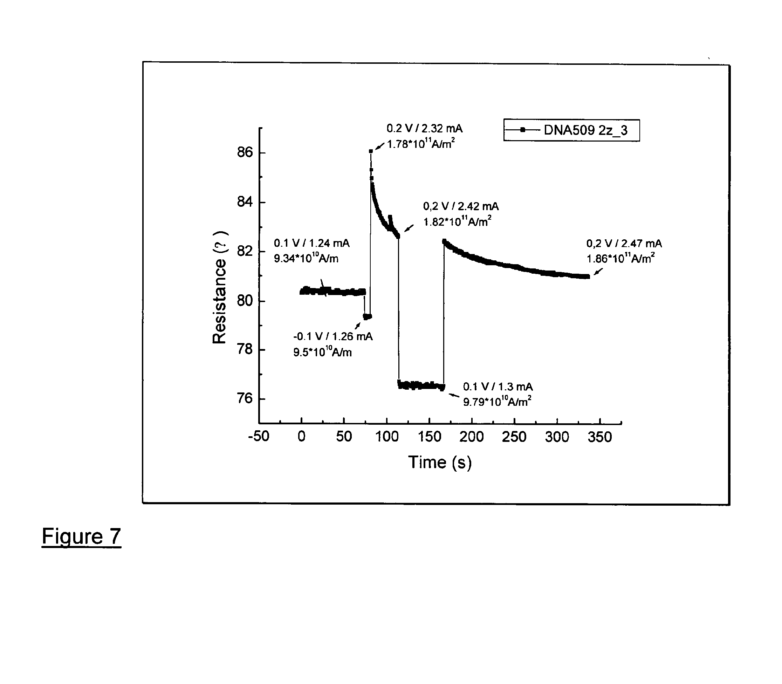

Fig. 6 shows an SEM image of a single metallized DNA nanowire on a polysterene surface with several nanowires, whereas one of the nanowires, indicated by arrows, has been utilized for obtaining the measurement results shown in Fig. 7.

Fig. 7 shows the data obtained during the so-called "current-annealing" of this wire, i.e. the result obtained during biasing this wire with a certain current density according to the invention.

The current density J_{D} was adjusted to provide a decreasing resistivity over time. As can be seen in Fig. 7, the initial bias voltage of 0,1 V led to a current of 1,24 mA and a current density of 9,34 * 10¹⁰ A/m² (taking into account the wire length of 6,5 µm and a diameter of 130 nm).

As can be seen, with a bias voltage of 0,1 V the resistance was stable at a level of about 80,4 Q. After however increasing the bias voltage to 0,2 V, the current has been increased to 2,32 mA, giving a current density of 1,78 * 10¹¹ A/m². As can be clearly seen in Fig. 7, the resistance tremendously decreases versus time. Only after biasing the system with a bias voltage of 0,2 V for 40 seconds, whereafter the bias voltage was returned to 0,1 V, the wire resistance has irreversibly dropped from 80,4 Ω to 76,6 Ω, which corresponds to a reduction of about 4,7%.

As can be further seen in Fig. 7, the resistance can be further decreased by again applying a bias voltage of about 0,2 V, as explained above.

It is assumed that the application of a bias by a current density J_{D} leads to a controlled growth of grains in the polycrystalline, metallic DNA wire. The density of grain boundaries decreases and therefore the wire resistivity also decreases.

For however the increasing of resistivity at an application of a bias with a higher current density J_{I} it is assumed that an excessive growth of grains to large crystals will occur, and eventually a de-wetting of the metal layer from the surface takes place. This leads to growing constrictions along the wire, which increases the wire resistivity. This can finally lead to the result that the wire might fail because de-wetting of the surface dominates, large metallic crystals forms and gaps between the crystals may be introduced.

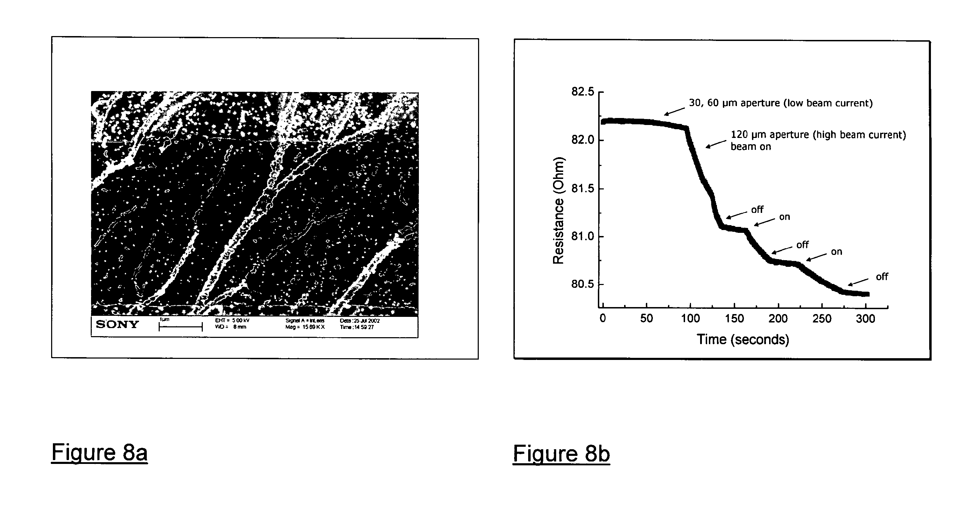

Fig. 8a shows a metallized DNA wire on a polysterene substrate between two electrodes. An electron beam at 5 kV (apertures between 30 and 120 µm) was focused on the wire area.

Fig. 8b shows a change of the resistance of the wire plus electrodes versus an electronic beam treatment time for different apertures. Using an aperture of 30 µm and 60µm, corresponding to a beam current of 100 pA and 250 pA, the change of the resistance versus time has been very small. The irradiated area was about 1,05 * 10⁻⁷ cm², therefore the corresponding current density was 9,5 * 10⁻⁴ A/cm² for 100 pA and 2,4 * 10⁻³ A/cm² for 250 pA.

As, however, the aperture has been increased to 120 µm (corresponding to a beam current of 600 pA), a significant change of the wire resistivity has been initiated, as can be clearly seen in the graph of fig. 8b. The corresponding density was 5,7 * 10⁻³ A/cm² in this case.

After the electron beam has been switched off, the change of the resistance has been decreased to a significantly smaller value.

When the beam has been switched on again, the previous drop rate of the resistance was essentially re-established, as can be also clearly seen in Fig. 8b.

For this measured example, the resistance decreased in total from 82,2 Ω to 80,5 Q, corresponding to about 2% decrease.

It shall be mentioned at this point that for the example shown in Fig. 8a and Fig. 8b no localised defects are present, but the resistivity is limited by the presence of a large density of grain boundaries. It is assumed that the decreasing of resistivity is initiated by re-organising of the wire structure and fusing a fraction of the grain boundaries together by the treatment.

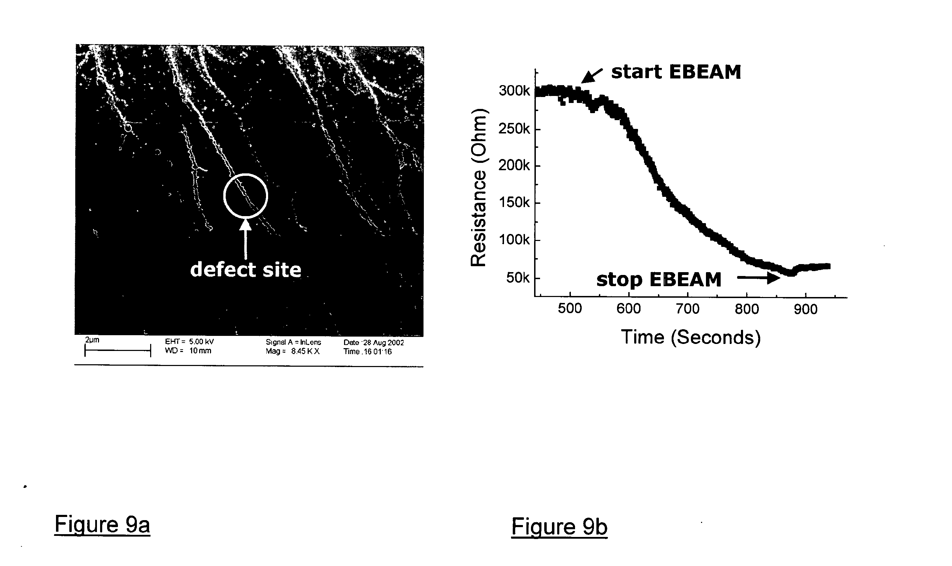

Fig. 9a shows a further example and a defect in a metallized DNA wire, which has been detected by applying an external voltage to the electrodes. An electron beam at 5 kV (aperture 120 µm, beam current 600 pA) was focused on the defective area. The focused area was estimated to be about 90 nm². This gives a current density of about 66,7 A/cm².

Fig. 9b shows the change of the resistance versus the time during which the electronic beam treatment has been applied. The resistance of the DNA wire starts to decrease immediately when the electronic beam has been switched on and still stays at the lower level even after the electronic beam has been switched off again, clearly indicating that the decreasing of the resistance will be maintained permanently.

The overall resistance decreased in this example by a factor of about 5 from 302,3 kΩ to 59,8 kΩ.

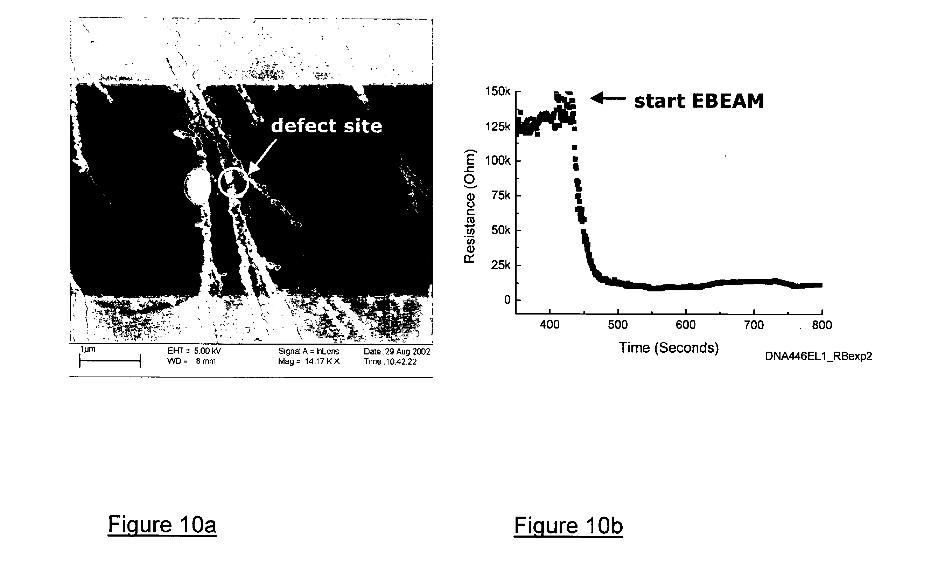

Figs. 10a and 10 b show a similar example as shown in Fig. 9. Fig. 10a is an SEM picture of a DNA wire with a clear defect in the center. An electron beam at 5 kV (aperture 60µm, beam current 250pA) was focused on the defective area. The current density was about 27,8 A/cm².

Fig. 10b shows, similarly to Fig. 9b, the change of the resistance versus time during which the electron beam treatment has taken place. As can be clearly seen in Fig. 10b, the resistance of the DNA wire decreases when the electron beam is switched on and saturates at a lower level. It has to be noticed here that there is a saturation even in case the electronic beam treatment is continued, as it is shown in this case.

The overall resistance decreases by a factor of about 12,6, namely from 139 kΩ to 11 kΩ.

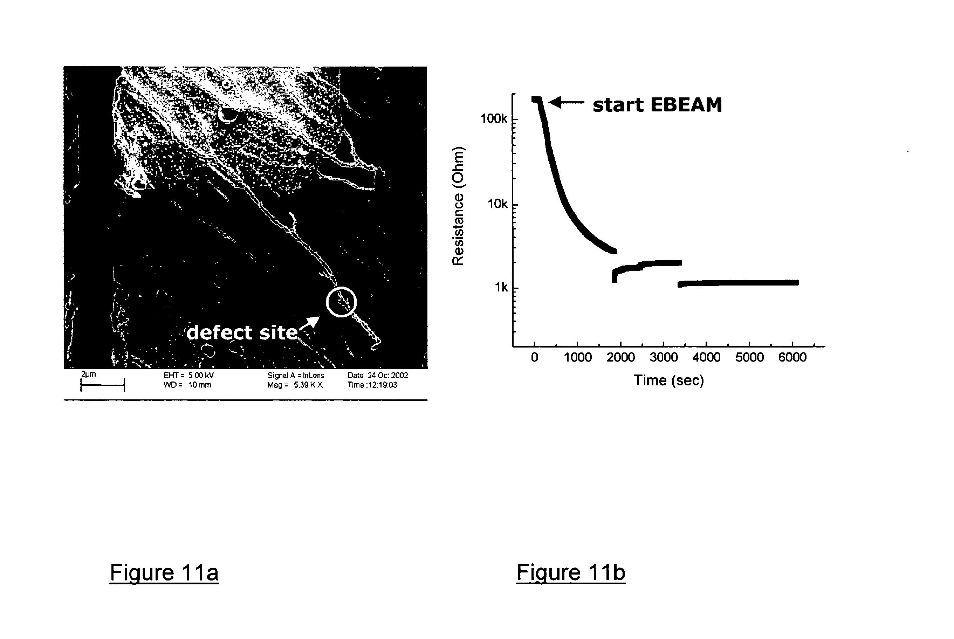

Figs. 11a and 11b show a still further example, whereas Fig. 11a shows an SEM picture of a DNA wire that had a high contact resistance to the lower electrode, as has been determined in an external biasing experiment. The image shows the situation when a voltage of -5V was applied to the upper electrode.

According to the invention an electron beam at 5kV (aperture 120 µm, beam current 1 nA) was focussed onto the defective area. The current density was at a range of about 111 A/cm².

Fig. 11b shows the decrease of the resistance (log-scale) versus time during which an electron beam treatment took place. Again, the resistance of the DNA wire decreases during the time in which an electron beam is switched on, and the resistance of the DNA wire saturates at a lower level. The overall resistance decreased by a factor of about 100 from 100 kΩ to 1 kΩ.

As can be also seen in Fig. 11b during the electron beam treatment two discrete jumps of the resistance have taken place after about 2000 seconds of treatment and after about 3400 seconds of treatment with the electron beam. These two discrete jumps indicate spontaneous restructuring of grains in the irradiated area.

The features of the present invention disclosed in the specification, the claims and/or the drawings, may both separately and in any combination thereof, be material for realising the invention in various forms thereof.

### Reference Numerals

- 10: electrode
- 20: nanowire
- 22: nanowire
- 24: nanowire
- 30: defect
- 32: defect
- 34: defect
- 35: repaired defect
- 100: electron source
- 102: primary electron beam
- 110: magnetic lenses
- 120: electrostatic lenses
- 150: backscattered electrons
- 160: secondary electrons
- 170: detector for backscattered electrons
- 200: sample (with nanoscaled structure)
- 210: interaction volume
- 220: secondary emission region
- 230: electrodes

## Claims

1. Method for defect and conductivity engineering of a conducting nanoscaled structure or at least a part of it
- by generating heat-induced migration, melting, sputtering and/or evaporation of conductive material of the nanoscaled structure by directing a focused electron beam on the nanoscaled structure or an individual portion of it to be engineered and/or
- by applying one or multiple wires of the conducting nanoscaled structure by applying a current density J_{D,I} whereas the current density J_{D,I} has a value below a critical current density J_{C,} which is the current per cross-section area of the wire at which the wire fails due to overheating and electromigration, and not lower than 3 orders of magnitude below said critical current density J_{C}.

2. Method according to claim 1, **characterized in that** a portion of the nanoscaled structure to be engineered is a gap region to be repaired, whereby the focused electron beam is directed onto said gap region including defect edges and generates heat-induced migration, melting, sputtering and/or evaporation of the conductive material of the defect edges into the gap between said defect edges, filing the gap and connecting said defect edges.

3. Method according to claim 1 or 2, **characterized in that** the electron beam has an accelerating beam voltage between 0,1 kV and 50 kV, preferably between 3kV and 10kV.

4. Method according to one of the preceding claims, **characterized in that** the electron beam has a current density of 1 to 100 A/cm².

5. Method according to one of the preceding claims, **characterized in that** the electron beam has an absolute beam current of 10 to 1000 pA, preferably 20 to 500 pA.

6. Method according to one of the preceding claims, **characterized in that** the electron beam will be applied in a scanning modus with a scanning window having a diameter or side lengths between 10 nm and 100 nm.

7. Method according to claim 6, **characterized in that** an individual portion of the conducting nanoscaled structure to be engineered is centered in the scanning window.

8. Method according to one of the preceding claims, **characterized in that** the electron beam has a beam diameter of 1 to 50 nm.

9. Method according to one of the preceding claims, **characterized in that** a working distance to the conducting nanoscaled structure is between 2 mm and 10 mm.

10. Method according to one of the preceding claims, **characterized in that** an electron doses of totally 1 to 500 mC/cm² is applied for the engineering of one individual portion.

11. Method according to one of the preceding claims, also including a step of inspecting said conductivity nanoscaled structure by directing an electron beam onto a portion of the conducting nanoscaled structure to be inspected and detecting backscattered electrons.

12. Method according to claim 11, **characterized in that** during the step of inspecting, a beam of primary electrons is accelerated to high potential by an electric field and retarded by a retarding field before reaching the conducting nanoscaled structure.

13. Method according to claim 11 or 12, **characterized in that** a first detection means only detects backscattered electrons and a second detection means detects both secondary electrons and backscattered electrons.

14. Method according to one of the claims 11 to 13, **characterized in that** the electron beam during the step of inspecting said conducting nanoscaled structure applies an electron doses of totally 0,1 to 10 mC/cm².

15. Method according to one of the claims 11 to 14, **characterized in that** the electron beam during the step of inspecting has an absolute beam current between 1 pA and 500 pA, preferably between 20 pA and 100 pA.

16. Method according to one the claims 11 to 15, **characterized in that** the electron beam during the step of inspecting has an accelerating beam voltage between 0,01 and 50 kV, preferably between 1 kV and 10kV.

17. Method according to claims 11 to 16, **characterized in that** said retarding field retards the primary electrons of the electron beam to an energy of 2% to 10% of its maximum energy generated by said electric field.

18. Method according to one of the preceding claims, **characterized in that** a focused electron beam is directed onto a conducting nanoscaled structure or a portion of it for a time interval of up to 6000 seconds.

19. Method according to one of the preceding claims, **characterized in that** a focused electron beam is directed onto a conducting nanoscaled structure or a portion of it for a time interval between 1 second and 4000 seconds, especially between 1000 seconds and 2000 seconds.

20. Method according to one of the preceding claims, **characterized in that** the current density J_{D,I} is adjusted to less than one order of magnitude below the critical current density J_{C}.

21. Method according to one of the preceding claims, **characterized in that** a current density J_{D} for decreasing the resistivity of one or multiple wires of the nanoscaled structure is between 0,01 * J_{C} and 0,1 * J_{C}.

22. Method according to one of the claims 1 to 21, **characterized in that** a current density J_{I} for increasing the resistivity of a wire or multiple wires of the nanoscaled structure is higher than the current density J_{D} for decreasing the resistivity.

23. Method according to claim 22, **characterized in that** the current density J_{I} for increasing the resistivity is between 0,1 * J_{C} and 0,9 * J_{C}.

24. Method according to one of the preceding claims, **characterized in that** the wire or multiple wires of the nanoscaled structure are biased by a current density J_{I} or J_{D} for a time interval of up to 5000 seconds.

25. Method according to one of the preceding claims, **characterized in that** the wire or multiple wires of the nanoscaled structure are biased by a current density J_{I} or J_{D} for a time interval shorter than 1000 seconds.

26. Method according to one of the preceding claims **characterized in that** the wire or multiple wires of the nanoscaled structure are biased by a current density J_{I} or J_{D} for a time interval shorter than 500 seconds.

27. Method according to one of the preceding claims **characterized in that** the wire or multiple wires of the nanoscaled structure are biased by a current density J_{I} or J_{D} for a time interval between 1 to 400 seconds, especially between 100 seconds and 250 seconds.

28. Use of a scanning electron microscope (SEM) system having a filter for detecting backscattered electrons for a method according to one of the claims 1 to 27.

29. Use of a scanning electron microscope system according to claim 28, **characterized in that** the scanning electron microscope is designed to have an aperture between 10 µm and 100 µm, preferably between 30 µm and 60 µm.

30. Use of a scanning electron microscope system according to claim 28 or 29, **characterized in that** the filter for detecting backscattered electrons comprises an annular backscattered electrons detector (102).
